# EUROPÄISCHE PATENTSCHRIFT

(11) **EP 0 364 711 B1**
(45) Veröffentlichungstag und Bekanntmachung des Hinweises auf die Patenterteilung: **09.02.1994**
(21) Anmeldenummer: 89116240.6
(22) Anmeldetag: 02.09.1989
(51) Int. Cl.: H03G 1/04

(54) **Schaltungsanordnung zur Verstellung der Grösse eines Signals**
Signal level adjustment circuit arrangement
Circuit de commande du niveau d'un signal

(30) Priorität: 07.10.1988 DE 3834143
(43) Veröffentlichungstag der Anmeldung: 25.04.1990
(73) Patentinhaber: Deutsche Thomson-Brandt GmbH, 78003 Villingen-Schwenningen (DE)
(72) Erfinder: Thanheiser, Wilhelm, D-7730 Villingen-Schwenningen (DE)

(56) Entgegenhaltungen:
- DE-A- 3 006 628
- DE-A- 3 008 033
- US-A- 4 742 312
- ELEKTOR ELECTRONICS, Band 14, Nr. 158, Juli/August 1988, Seite 58, London, GB; "Stepped volume control"
- E.D.N. ELECTRICAL DESIGN NEWS, Band 27, Nr. 18, September 1982, Seite 192, Boston, Massachusetts, US; W. HEINZER: "Eliminate transients in programmable-gain amps"

## Beschreibung

Die Erfindung betrifft eine Schaltungsanordnung zur elektronischen Pegeleinstellung von Signalen in diskreten Schritten mit Hilfe eines digital ansteuerbaren C-MOS-Schalters.

Derartige Schalter werden in zunehmendem Maße wegen ihrer raumsparenden und auch preiswerten Ausführung in Audio-Geräten eingesetzt. Bei hochwertigen Audio-Geräten wie z.B. bei CD-Spielern oder Digital-Tonband-Geräten oder auch bei Bandgeräten mit integrierten hochwertigen Geräuschreduktionssystemen werden Störabstände von mehr als 90 db erreicht. Es werden extrem niedrige Klirrfaktoren insbesondere bei der digitalen Tonaufzeichnung erzielt. Es hat jedoch wenig Sinn, die genannten Daten für HiFi-Geräte derart optimal auszulegen, wenn Schwachstellen diese Daten wieder zunichte machen. Solche Schwachstellen sind elektronische Lautstärke-Einsteller bekannter Art und auch C-MOS-Schalter, welche z.B. bei der schrittweisen Verstellung der Lautstärke eines Audio-Signals Knackgeräusche hervorrufen, die besonders im tieferen Frequenzbereich eines Audiosignals sehr störend in Erscheinung treten. Einen Schalter, der keine Knackgeräusche hervorruft, ist bis heute nicht zu erhalten, wenn er auch die Forderungen bezüglich Klirr- und Störabstand erfüllt.

Es ist eine Anordnung zur Untersrückung von Knackgeräuschen bei der Verstellung der Lautstärke bei NF-Verstärkern bekannt, bei welcher Umschaltgeräusche dadurch eliminiert werden, daß ein in dem Signalweg angeordneter Längsregler hochohmig wird, wodurch eine Zeitverzögerung der entsprechenden Schaltvorgänge eingeführt wird und deswegen die Wirkung nach einer gegebenen Zeitspanne nachläßt. So entsteht ein allmählicher Übergang des Pegels. Außerdem ist ein Querregler vorgesehen, der in seiner Wirkung zum Längsregler entgegengesetzt ist. Es findet hierbei keine Kompensation statt, sondern die resultierende Gesamtänderung der zu beeinflussenden Größe erfolgt in der gleichen Richtung, d.h. der Einfluß des Querreglers ist doppelt invertiert, erstens durch die Tatsache, daß es sich um einen Querregler handelt, zweitens durch die gegensinnige Ansteuerung. Somit wird z.B. im Falle des Aufsteuerns der Längsregler niederohmig und der Querregler hochohmig, das Signal steigt somit mit der Zeitkonstante der RC-Glieder an, eine gleichzeitige Kompensation findet nicht statt (DE-A-30 08 033).

In der Zeitschrift "Elektor Electronics", Band 14, Nr. 158, Juli/August 1988, Seite 58, London, GB wird in einem unter der Überschrift "Stepped Volume Control" eine Schaltungsanordnung beschrieben, die einen MOS-Schalter verwendet, wie er dem im Oberbegriff des Patentanspruchs erwähnten enstpricht. Auf eine Unterdrückung von Störgeräuschen wird in diesem Artikel jedoch nicht eingegangen.

Der Erfindung liegt die Aufgabe zugrunde, einen mit Knackgeräuschen behafteten Schalter derart zu ergänzen, daß er auch für HiFi-Geräte ohne Störungen zu erzeugen verwendbar ist. Diese Aufgabe wird durch die im Patentanspruch 1 angegebene Maßnahmen gelöst. Weitere vorteilhafte Ausgestaltungen der Erfindung ergeben sich aus den Unteransprüchen.

Nachstehend wird die Erfindung an einem Ausführungsbeispiel und in ihrer Wirkungsweise mit Hilfe der Zeichnung erläutert.
- Figur 1: zeigt ein Blockschaltbild der Erfindung,
- Figur 2: zeigt Diagramme zur Wirkungsweise der Erfindung,
- Figur 3: zeigt ein ausführliches Schaltungsbeispiel der Erfindung.

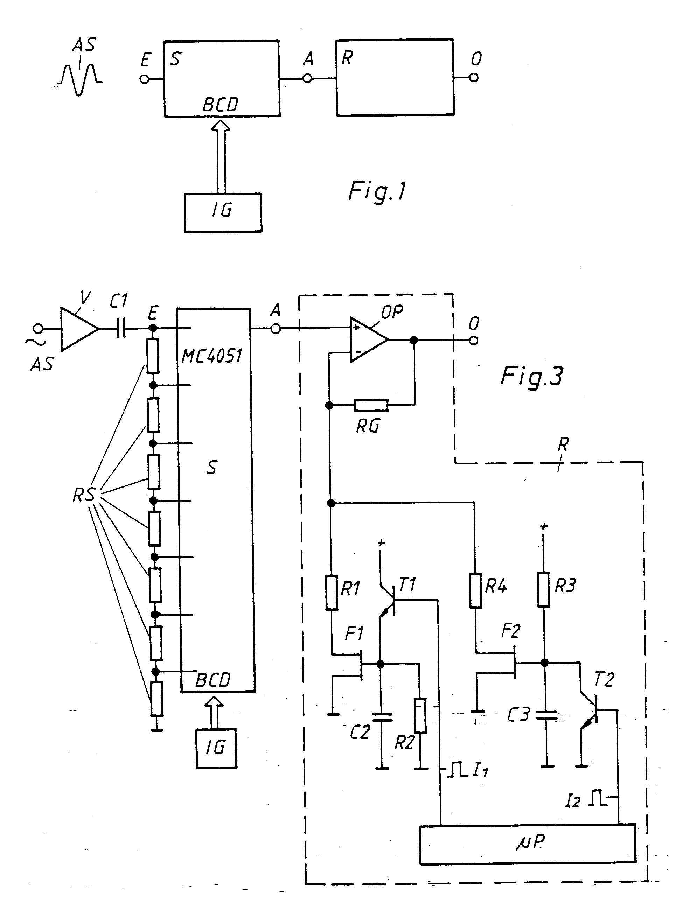

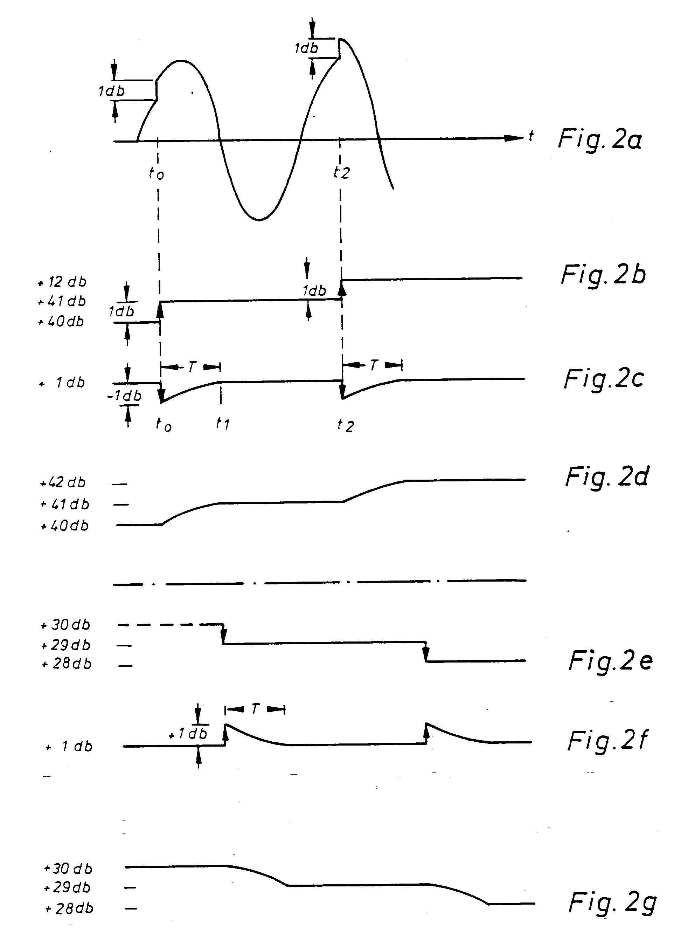

In Figur 1 ist mit S ein elektronischer Schalter (C-MOS-Technik) gezeigt, an dessen Eingang E ein Audiosignal AS anliegt, welches durch diesen Schalter z.B. in 1-db-Schritten veränderbar am Ausgang A abnehmbar ist. Zur schrittweisen Änderung des Signals AS dient ein Inkrementalgeber IG, der bei Verstellung Impulse I abgibt, die je nach Betätigungsrichtung Signale im BCD-Code erzeugen, mit denen der Schalter S angesteuert wird. Am Ausgang A entstehen Spannungsprünge des Signals AS in db-Schritten. Wie bereits weiter oben erwähnt, werden diese Sprünge besonders im niedrigeren Frequenzbereich des Signals AS unangenehm hörbar. Mit dem Schalter S ist deshalb eine Anordnung R verbunden, die das Ausgangssignal AS entgegengesetzt zu seiner Veränderung beeinflußt und zwar in solcher Größe, die dem durch den Schalter S erzeugten Schritt entspricht. Wenn, wie angenommen, der Schalter S das Eingangssignal um 1 db verändert, dann beeinflußt die Anordnung R das Ausgangssignal des Schalters S ebenfalls um 1 db, jedoch entgegengesetzt. Beim Hochregeln des Signals wird bei jedem Schritt des Schalters S um +1 db die Anordnung R zu Beginn des Schrittes auf -1 db geschaltet. Die Anordnung R beeinlußt das Signal von dieser Einstellung ab kontinuierlich abnehmend nach einer vorgebbaren Zeitkonstante auf 0db, so daß von diesem Zeitpunkt ab der ganze durch den Schalter S eingestellt Schritt zur Geltung kommen kann. Dieser Vorgang ist in Figur 2 dargestellt. Figur 2a zeigt ein Audiosignal AS, welches zum Zeitpunkt t0 auf einen um 1db höheren Wert eingestellt wird. Dieser Signalsprung erzeugt das unangenehme Knacken in der Wiedergabevorrichtung. Figur 2b zeigt die schrittweisen Signalsprünge des Ausgangssignals des Schalters S. Figur 2c zeigt, wie zu Beginn die Anordnung R auf -1 db gestellt wird, die den Spannungsprung kompensiert. Die Anordnung R wird kontinuierlich auf den Wert 0 db abnehmend automatisch herabgeregelt, so daß nach der Zeitkonstante T zum Zeitpunkt t1 der volle Schritt zur Wirkung kommen kann. Zum Zeitpunkt t2 wird ein neuer Schritt erzeugt. Zum gleichen Zeitpunkt erfolgt die Einstellung der Anordnung R auf -1 db usw. Die Figur 2d zeigt den Verlauf des Signals am Ausgang O der Anordnung R. Die Figuren 2e, f und g zeigen die Wirkungsweise der Anordnung in entgegengesetzter Richtung, ohne Bezugsnahme auf die Signaldarstellung nach Figur 2a.

Mit der Figur 3 wird die Erfindung am Beispiel einer technischen Ausführung beschrieben.
Mit S ist wieder der C-MOS-Schalter zur digitalen Pegeleinstellung des Signals AS gezeigt, welches diesem über einen Eingangsverstärker V und einen Koppelkondensator C1 zugeführt wird. Der C-MOS-Schalter S ist in bekannter Weise mit Widerständen RS beschaltet, die entsprechend einer durch den Inkrementalgeber IG am BCD-Eingang anliegenden Information zu- oder abschaltbar sind, so daß am Ausgang A des C-MOS-Schalters S das Ausgangssignal in diskreten Schritten von z.B. 1 db abnehmbar ist. Dieses Signal wird auf den nichtinvertierenden Eingang eines in der Anordnung R vorgesehenen Operationsverstärkers OP gegeben, dessen Ausgang O über den GegenkopplungsWiderstand RG rückgekoppelt ist. An den invertierenden Eingang des Operationsverstärkers OP sind zwei parallelgeschaltete Zweige geschaltet, welche die jeweilige Signalerhöhung bzw. Signalabsenkung bei der schrittweisen Pegeländerung durch den C-MOS-Schalter verursachen. Der eine Zweig besitzt den Widerstand R1, der über die Drain-Source-Strecke eines elektronischen Schalters F1 auf das Bezugspotential geschaltet ist und dessen Gate-Elektrode einerseits über ein Zeitglied R2,C2 auf Bezugspotential liegt und andererseits über eine Schaltstufe T1 auf ein positives Potential schaltbar ist. Der andere Zweig besitzt den Widerstand R4, der über die Drain-Source-Strecke eines weiteren elektronischen Schalters F2 auf Bezugspotential geschaltet ist und dessen Gate-Elektrode einerseits über einen Widerstand R3 auf einem positiven Potential und andererseits über einen Kondensator C3 auf Bezugspotential liegt. Der Widerstand R3 und der Kondensator C3 bilden ein weiteres Zeitglied. Parallel zum Kondensator C3 liegt eine Schaltstufe T2. Die Beschaltung ist derart, daß bei positivem Gate der jeweilige Schalter F1 oder F2 leitend gesteuert wird. Bei einem anderen Leitungstyp müssen selbstverständlich die Potentiale entgegengesetzt sein. Die Schaltstufen T1 und T2 werden jeweils zu Beginn einer Pegeländerung am Ausgang A des C-MOS-Schalters S kurzzeitig geschlossen. Dieser Vorgang kann über einen Mikroprozessor uP per Software erfolgen, indem durch einen Impuls I1 bzw. I2 entweder die Schaltstufe T1 z.B. bei einer Pegelerniedrigung oder T2 z.B. bei einer Pegelerhöhung kurzzeitig betätigt wird. Die Schaltstufen T1 und T2 sind hier nur symbolisch als Transistorschalter dargestellt. Es sind auch andere Möglichkeiten zum Schließen der Schalter F1 und F2 denkbar.

Im Ruhezustand der Anordnung R ist der Schalter F1 hochohmig und der Schalter F2 niederohmig, so daß der Operationsverstärker OP eine durch die Widerstände RG und R4 definierte Verstärkung von z.B. +1 db besitzt, entsprechend einer Schrittweite des Schalters S. Bei einer schrittweisen Erhöhung des Pegels am Ausgang A wird die Schaltstufe T2 kurzzeitig geschlossen, so daß der Kondensator C3 des Zeitgliedes R3/C3 entladen wird. Der Schalter F2 wird hochohmig und die Verstärkung des Operationsverstärkers OP dadurch erniedrigt. Die Erniedrigung ist durch den Widerstand RG derart eingestellt, daß sie dem Betrag des Schrittes der Pegelerhöhung entspricht, diese also kompensiert von +1 db auf 0 db. Nach Ablauf der durch das Zeitglied R3/C3 vorgegebenen Zeitkonstante wird der Schalter F2 wieder niederohmig, so daß die Verstärkung des Operationsverstärkers OP wieder +1 db beträgt.

Bei einer schrittweisen Erniedrigung des Pegels am Ausgang A wird die Schaltstufe T1 kurzzeitig geschlossen, so daß der Kondensator C2 aufgeladen wird und der Schalter F1 niederohmig wird. Dadurch wird der Widerstand R1 dem Widerstand R4 parallelgeschaltet und der Gesamtwiderstand gegen das Bezugspotential verkleinert. Das Teilerverhältnis von RG zu R1 parallel R4 ist derart eingestellt, daß die Verstärkung des Operationsverstärkers OP um 1 db auf +2 db erhöht wird. Der Kondensator C2 entlädt sich über den Widerstand R2, so daß nach der Zeitkonstante R2C2 der Schalter F1 wieder hochohmig wird und dadurch der Operationsverstärker OP wieder den durch die Widerstände RG,R4 vorgegebenen Verstärkungsgrad von +1 db erreicht.

Es sei ausdrücklich darauf hingewiesen, daß die Anordnung R auch anders aufgebaut sein kann als in der mit Figur 3 beschriebenen Weise. Wesentlich ist nur, daß diese den durch den Schalter S verursachten Schritt zunächst kompensiert und die Kompensation stetig abnehmend wieder aufhebt. Die Erfindung wurde am Beispiel mit Schritten von jeweils einem db erklärt. Es versteht sich, daß die Erfindung auch angewendet werden kann, wenn die Schritte eine andere Größe besitzen. Entsprechend ist die Anordnung R zu dimensionieren, damit auch diese Schritte kompensiert werden.

## Patentansprüche

1. Schaltungsanordnung zur elektronischen Pegeleinstellung von Signalen (AS) in diskreten Schritten mit Hilfe eines digital ansteuerbaren C-MOS-Schalters (S), **dadurch gekennzeichnet**, daß mit dem Ausgang des C-MOS-Schalters (S) eine Anordnung (R) verbunden ist, welche eine Kompensationsgröße erzeugt, die die vom C-MOS-Schalter (S) erzeugten diskreten Schritte zunächst kompensiert, und daß die Kompensationsgröße stetig abnehmend nach einer vorgebbaren Zeitkonstante die diskreten Schritte voll wirksam werden läßt.

2. Schaltungsanordnung nach Anspruch 1, **dadurch gekennzeichnet**, daß die Anordnung (R) aus einem Operationsverstärker (OP) besteht, auf dessen nichtinvertierenden Eingang das Signal aus der Schaltstufe (S) gegeben wird und dessen Ausgang (O) über einen ersten Widerstand (RG) mit dem invertierenden Eingang verbunden ist, und daß der invertierende Eingang über einen zweiten Widerstand (R4) mit einem in Serie dazu gelegtem ersten elektronischen Schalter (F2) nach Massepotential geschaltet ist, wobei der erste elektronische Schalter (F2) im Ruhezustand leitend vorgespannt ist und der zweite Widerstand (R4) und der erste Widerstand (RG) so dimensioniert sind, daß der Operationsverstärker (OP) die Verstärkung eines Schalterschrittes besitzt.

3. Schaltungsanordnung nach Anspruch 2, **dadurch gekennzeichnet**, daß die Vorspannung (+) über einen dritten Widerstand (R3) an die Steuerelektrode des ersten elektronischen Schalters (F2) gelegt ist, welche über einen ersten Kondensator (C3) auf Bezugspotential liegt, und daß der erste Kondensator (C3) mittels eines zweiten Schalters (T2) überbrückbar ist.

4. Schaltungsanordnung nach Anspruch 2, **dadurch gekennzeichnet**, daß parallel zum zweiten Widerstand (R4) ein vierter Widerstand (R1) in Serie zu einem dritten elektronischen Schalter (F1) nach Massepotential geschaltet ist, wobei der dritte elektronische Schalter (F1) im Ruhezustand hochohmig ist, und daß die Steuerelektrode des dritten elektronischen Schalters (F1) über die Parallelschaltung eines zweiten Kondensators (C2) mit einem fünften Widerstand (R2) auf Massepotential geschaltet ist, und daß die Steuerelektrode des dritten elektronischen Schalters (F1) kurzzeitig mittels eines vierten Schalters (T1) an eine den dritten elektronischen Schalter (F1) leitend schaltende Vorspannung (+) anschaltbar ist.

5. Schaltungsanordnung nach Anspruch 1, 2, 3 oder 4, **dadurch gekennzeichnet**, daß die Zeitkonstante der Zeitglieder (R2, C2; R3, C3) derart gewählt ist, daß sie kleiner ist als der zeitliche Abstand zweier aufeinander folgender Impulse eines die Schaltstufe (S) ansteuernden Inkrementalgebers (IG).

## Claims

1. A circuit arrangement for the electronic level adjustment of signals (AS) in discrete steps with the aid of a digitally driveable C-MOS switch (S), characterised in that the output of the C-MOS switch (S) is connected to an arrangement (R) which generates a compensating variable which initially compensates the discrete steps produced by the C-MOS switch (S), and that the compensating variable is continuously reduced to cause the discrete steps to take full effect after a predeterminable time constant.

2. A circuit arrangement as claimed in Claim 1, characterised in that the arrangement (R) consists of an operational amplifier (OP), the non-inverting input of which is supplied with the signal from the switching stage (S) and the output (O) of which is connected via a first resistor (RG) to the inverting input, and that the inverting input is connected to earth potential via a second resistor (R4) with a first electronic switch (F2) arranged in series therewith, where the first electronic switch (F2) is conductively biased in the rest state and the second resistor (R4) and the first resistor (RG) are dimensioned such that the operational amplifier (OP) possesses the amplification of one switch step.

3. A circuit arrangement as claimed in Claim 2, characterised in that the bias voltage (+) is connected via a third resistor (R3) to the control electrode of the first electronic switch (F2), which control electrode is connected to reference potential via a first capacitor (C3), and that the first capacitor (C3) can be bridged by means of a second switch (T2).

4. A circuit arrangement as claimed in Claim 2, characterised in that in parallel to the second resistor (R4) a fourth resistor (R1) in series with a third electronic switch (F1) is connected to earth potential, where the third electronic switch (F1) has high resistance in the rest state, and that the control electrode of the third electronic switch (F1) is connected to earth potential via the parallel arrangement of a second capacitor (C2) with a fifth resistor (R2), and that the control electrode of the third electronic switch (F1) can be temporarily connected by means of a fourth switch (T1) to a bias voltage (+) which switches the third electronic switch (F1) conductive.

5. A circuit arrangement as claimed in Claim 1,2,3 or 4, characterised in that the time constant of the timing elements (R2,C2; R3,C3) is selected such that it is smaller than the interval of time between two consecutive pulses of an incremental transmitter (IG) which drives the switching stage (S).

## Revendications

1. Circuit pour le réglage électronique du niveau de signaux (AS) en pas discrets à l'aide d'un commutateur CMOS (S) qui peut être amorcé numériquement, **caractérisé en ce** qu'un dispositif (R) est relié à la sortie du commutateur CMOS (S), ce dispositif produisant une grandeur de compensation qui compense tout d'abord les pas discrets produits par le commutateur CMOS (S) et que la grandeur de compensation laisse devenir entièrement actifs les pas discrets en décroissant continuellement après une constante de temps qui peut être prédéterminée.

2. Circuit selon la revendication 1, **caractérisé en ce** que le dispositif (R) se compose d'un amplificateur opérationnel (OP) à l'entrée de non inversion duquel le signal est donné à partir de l'étage de commutation (S) et dont la sortie (0) est reliée, par une première résistance (RG) à l'entrée d'inversion et que l'entrée d'inversion est montée, par l'intermédiaire d'une seconde résistance (R4) avec un premier commutateur électronique (F2) monté en série avec elle, sur le potentiel de la masse, le premier commutateur électronique (F2) à l'état de repos étant polarisé en étant conducteur et la seconde résistance (R4) et la première résistance (RG) étant dimensionnées de telle manière que l'amplificateur opérationnel (OP) possède l'amplification d'un pas de commutateur.

3. Circuit selon la revendication 2, **caractérisé en ce** que la polarisation (+) est appliquée par une troisième résistance (R3) à l'électrode de commande du premier commutateur électronique (F2), électrode qui est mise sur le potentiel de référence par un premier condensateur (C3) et que le premier condensateur (C3) peut être surmonté à l'aide d'un second commutateur (T2).

4. Circuit selon la revendication 2, **caractérisé en ce** qu'une quatrième résistance (R1) est montée parallèlement à la seconde résistance (R4) en série avec un troisième commutateur électronique (F1) sur le potentiel de la masse, le troisième commutateur électronique (F1) étant à valeur ohmique élevée à l'état de repos et que l'électrode de commande du troisième commutateur électronique (F1) est commutée sur le potentiel de la masse par le montage en parallèle d'un second condensateur (C2) et d'une cinquième résistance (R2) et que l'électrode de commande du troisième commutateur électronique (F1) peut être temporairement mise en circuit au moyen d'un quatrième commutateur (T1) sur une polarisation (+) qui rend conducteur le troisième commutateur électronique (F1).

5. Circuit selon la revendication 1, 2, 3 ou 4, **caractérisé en ce** que la constante de temps des relais de temporisation (R2, C2 ; R3, C3) est choisie de manière à être inférieure à l'écart dans le temps de deux impulsions consécutives d'un transmetteur incrémentiel (IG) qui excite l'étage de commutation (S).
